Europäisches Patentamt

European Patent Office

Office européen des brevets

(11) Publication number: **0 196 200 B1**

# EUROPEAN PATENT SPECIFICATION

(45) Date of publication of patent specification: **17.07.91**

(51) Int. Cl.⁵: **H01L 33/00**, H01S 3/02, H01S 3/133, H01L 31/14

(21) Application number: **86302086.3**

(22) Date of filing: **20.03.86**

(54) Semiconductor laser devices.

(30) Priority: **23.03.85 JP 42245/85 U**

(43) Date of publication of application:
**01.10.86 Bulletin 86/40**

(45) Publication of the grant of the patent:
**17.07.91 Bulletin 91/29**

(84) Designated Contracting States:
**DE FR GB NL**

(56) References cited:
**GB-A- 1 073 460**
**GB-A- 1 483 849**
**GB-A- 2 165 694**

(73) Proprietor: **SONY CORPORATION**
**7-35 Kitashinagawa 6-Chome Shinagawa-ku Tokyo 141(JP)**

(72) Inventor: **Matsuda, Osamu Patents Division Sony Corporation 6-7-35 Kitashinagawa Shinagawa-ku Tokyo 141(JP)**

(74) Representative: **Thomas, Christopher Hugo et al D Young & Co 10 Staple Inn London WC1V 7RD(GB)**

## Description

This invention relates to methods of manufacturing and testing semiconductor laser devices, and to semiconductor wafers forming an intermediate product in such manufacture.

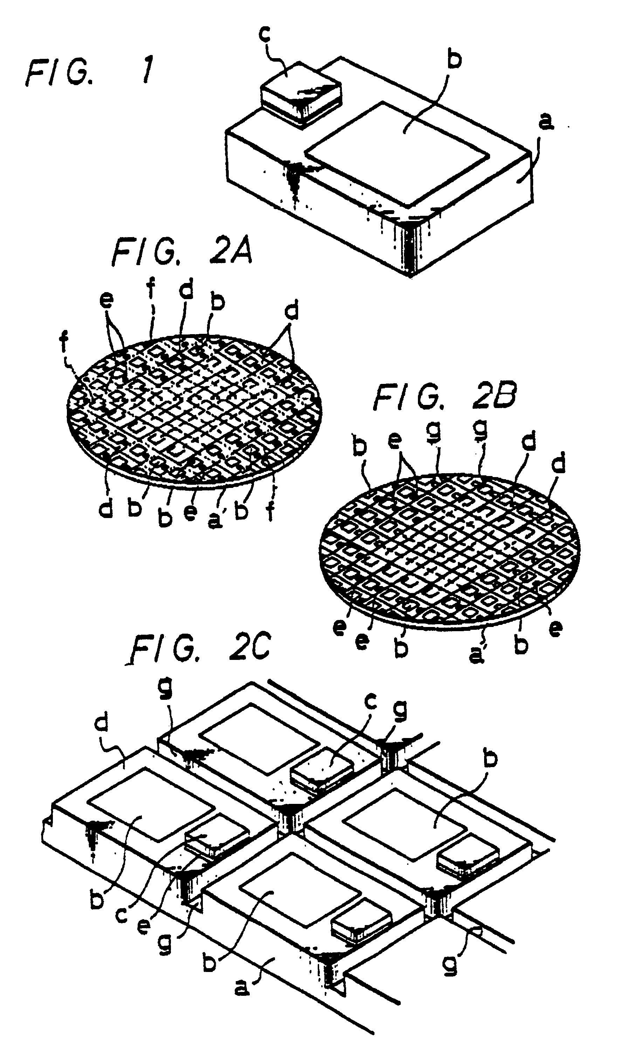

As shown in Figure 1 of the accompanying drawings, a semiconductor laser device has been previously proposed comprising an automatic power control (APC) photodiode b formed on a surface portion of a semiconductor substrate a (for example of $N^+$ type). A semiconductor laser chip c is mounted on a portion of the semiconductor substrate a near the portion where the APC photodiode b is formed (cf. for example GB-A- 1 483 849).

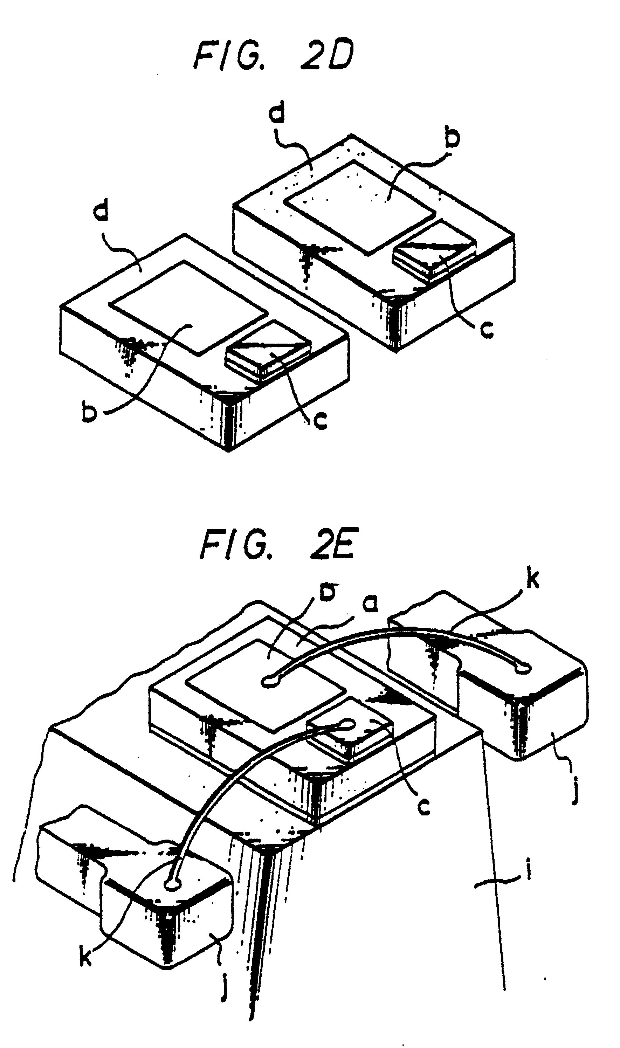

For manufacturing such a semiconductor laser device we have proposed a method generally as shown in Figure 2 of the accompanying drawings. Firstly, as shown in Figure 2A, a series of treatments are carried out on a semiconductor wafer containing a plurality of substrates a, a, ..., so that an APC photodiode b is formed on a part of each of element-forming regions d, d, ... Lines f partition the adjacent element-forming regions d, d, ... and indicate where the element-forming regions d, d, ... are to be diced. Then, as shown in Figure 2B, the surface of the semiconductor wafer is half-diced along the lines f, f, ... thereby to form grooves g, g, ... Thereafter, as shown in Figure 2C, a semiconductor laser chip c is positioned on a solder layer e of each of the element-forming regions d, d, ... While in this state, the semiconductor wafer is passed through a heating furnace (for example at a temperature of 250°C) thereby to carry out the chip bonding of the respective semiconductor laser chips c, c, ... simultaneously to their respective substrates a, a, ... Then, after the electrical characteristics and the optical characteristics have been measured and inspected, and the necessary screening carried out, the semiconductor wafer is separated along the grooves g,g, ... thereby to carry out pellet separation. Thereafter, as shown in Figure 2E, each pellet a is pellet-bonded to a heat sink i which is located on a surface of a stem (not shown). Leads j and j attached to the stem are wire-bonded to the laser chip c and to the electrode of the APC photodiode b respectively by wires k, to mount the semiconductor laser device.

In this method of producing the semiconductor laser device, since the semiconductor laser chip is not bonded to the semiconductor substrate of an individual pellet but is bonded to the semiconductor substrate of a wafer at element-forming regions, there is the advantage that the semiconductor laser chips can be bonded simultaneously on a vast number of element-forming regions formed on one semiconductor wafer. In addition, when the semiconductor substrate is still in the wafer state, an electrical characteristic, such as a threshold current Ith, can be measured by using a probe, and the screening carried out. Accordingly, not only the cost of bonding the semiconductor laser device can be decreased but also the cost of testing and screening can be decreased.

However, when the semiconductor substrate a is still in the wafer state, it is impossible to measure and test the intensity of the laser emission from the semiconductor laser chip c, and the symmetrical property of a far field pattern thereof. Thus, if there is cracking of the semiconductor laser chip, the laser emission cannot be generated or the laser emission cannot reach a prescribed reference value. Similarly, an asymmetrical property of the far field pattern may be caused relatively easily by the positional displacement of the semiconductor laser chip c in its direction relative to the semiconductor substrate a. If such positional displacement is beyond the tolerance range, the semiconductor laser device must be rejected. Such rejected products must be removed at as early a stage as possible, otherwise they are unnecessarily subjected to the pellet bonding to the heat sink i and the wire bonding, so increasing the costs.

According to one the present invention there is provided a method of manufacturing and testing semiconductor laser devices comprising the steps of:

forming an array of first photodetectors in one major surface of a semiconductor substrate, wherein each first photodetector is formed in a semiconductor laser device-forming region ;

mounting a semiconductor laser chip on the surface of each of said laser device-forming regions and adjacent to said first photodetector ;

forming a second photodetector in the surface of each of said laser device-forming regions and adjacent to said first photodetector and on the side thereof opposite to said laser chip ; and

using said second photodetector to test the laser emission characteristic of a laser chip on an adjacent semiconductor laser device-forming region during the manufacture of the laser devices prior to pelletizing the semiconductor substrate.

According to the present invention there is also provided a semiconductor wafer comprising:

a semiconductor substrate (1) with an array of semiconductor laser device-forming regions (13) seperated by grooves (15) formed on one major surface of said semiconductor substrate (1);

a respective first photodetector (5) formed in the surface of each said device-forming region (13);

a respective laser chip (3) mounted on the surface of each said device-forming region (13) and adjacent to the respective said first photodetector (5); and

a respective second photodetector (8) formed in the surface of each said device-forming region (13) and adjacent to the respective said first photodetector (5) and on the side thereof opposite to the respective said laser chip (3);
each said second photodetector (8) being positioned to test a laser emission characteristic of a said laser chip (3) on an adjacent said device-forming region (13).

The invention will now be described by way of example with reference to the accompanying drawings, throughout which like parts are referred to by like references, and in which:

Figure 1 is a perspective view showing an example of a previously proposed semiconductor laser device;

Figures 2A to 2E are perspective views respectively showing a previously proposed method of making a semiconductor laser device as shown in Figure 1;

Figure 3 is a perspective view showing an embodiment of semiconductor laser device according to the present invention;

Figure 4 is a cross-sectional view taken along a line II-II in Figure 3;

Figures 5A to 5D are perspective views respectively showing steps in a method of manufacturing the semiconductor laser device of Figures 3 and 4;

Figure 6 is a cross-sectional view illustrating the manner in which a region to be scribed is cut for pelletizing;

Figure 7A is a plan view used to explain an improved testing method; and

Figure 7B is a cross-sectional view of Figure 7A.

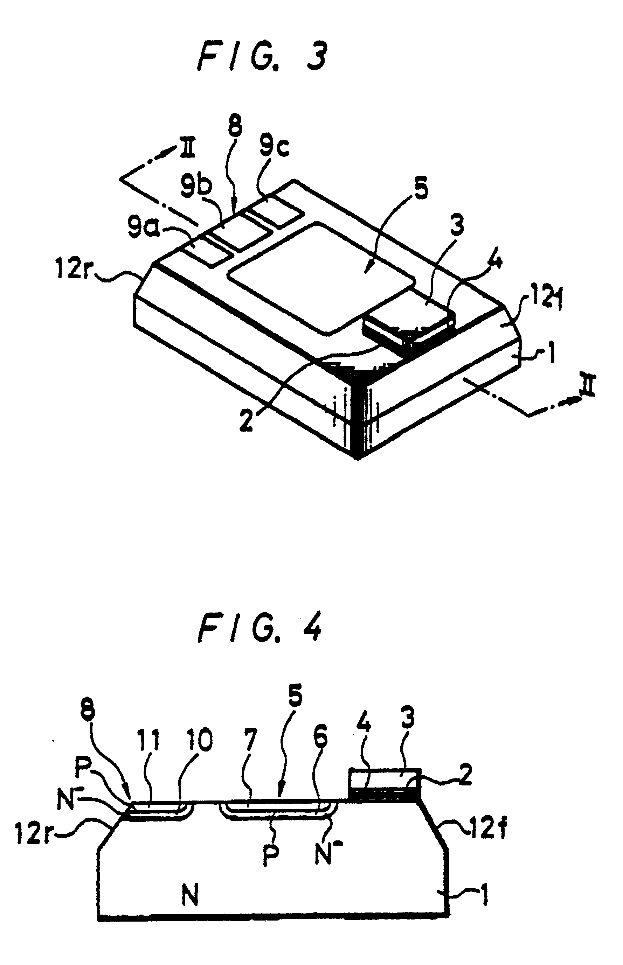

Figures 3 and 4 show a semiconductor substrate 1 of, for example, an N type, and a solder layer 2 that is formed on a major surface of the semiconductor substrate 1 at its front region. A semiconductor laser chip 3 is fixed by the solder layer 2 to the major surface of the semiconductor substrate 1. The semiconductor laser chip 3 has an active layer 4.

An APC photodiode 5 is formed in the major surface of the semiconductor substrate 1 at a side to the rear of the portion on which the semiconductor laser chip 3 is mounted. The APC photodiode 5 comprises the N type semiconductor substrate 1 itself, an $N^-$ type semiconductor region 6 selectively formed on a major surface portion of the semiconductor substrate 1, and a P type semiconductor region 7 selectively formed on the surface portion of the semiconductor region 6.

An inspection or testing photodiode 8 is formed in the major surface of the semiconductor substrate 1 at its rear side region, opposite to the laser chip 3. The testing photodiode 8 is used to check whether the laser emission reaches a predetermined value or not, and whether a far field pattern has a symmetrical property or not, etc., in the manufacturing stage of the semiconductor wafer before the semiconductor laser device is separated as a product. The testing photodiode 8 is separated into three photodiode elements 9a, 9b and 9c. Each of the photodiode elements 9a, 9b and 9c comprises the semiconductor substrate 1 itself, an $N^-$ semiconductor region 10 selectively formed on the major surface portion of the semiconductor substrate 1, and a P type semiconductor region 11 selectively formed on the surface portion of the semiconductor region 10.

Faces 12f and 12r are inclined by etching the upper portions of both front and rear end faces respectively of the semiconductor substrate 1. The photodiodes 9a, 9b and 9c are each exposed in the inclined face 12r. In the semiconductor laser device shown in Figures 3 and 4, a laser beam is emitted from the front end face of the semiconductor laser chip 3, or its laser beam emission end face (towards the lower right as viewed in Figure 3), and this laser emission is utilized to read data from, for example, an optical recording medium (for example, a laser disc). A laser beam is also emitted from the rear end face of the semiconductor laser chip 3, and this laser beam emission is sensed by the APC photodiode 5. Then, on the basis of the results sensed by the APC photodiode 5, contol is carried out to maintain the laser emission output constant.

The testing photodiode 8 for testing the semiconductor laser device during manufacture, is not necessary after the semiconductor laser device has been completely manufactured as a product. It is utilized to inspect the laser emission output and the symmetrical property of the far field pattern in the manufacturing process, particularly in the stage before pelletizing.

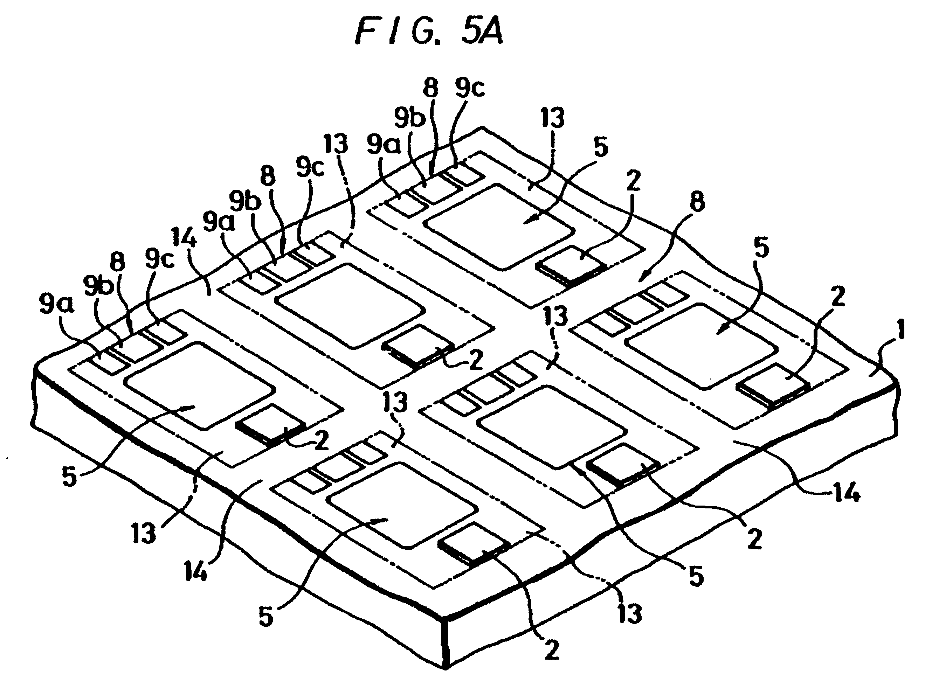

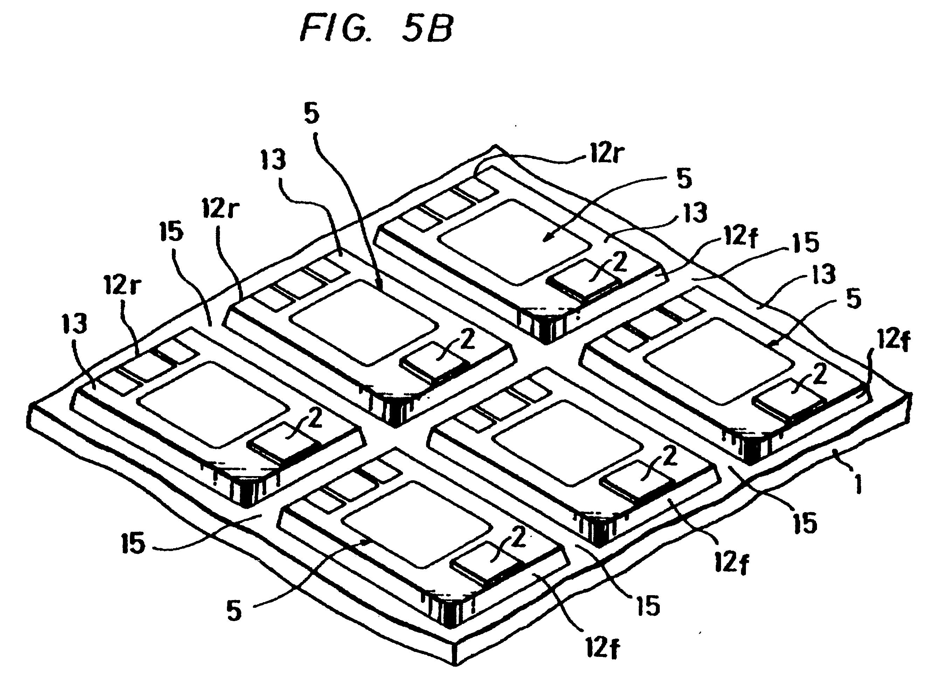

In order to explain at which stage in the manufacturing process of the semiconductor laser device, emission output and the symmetrical property of the far field pattern should be inspected and tested by utilizing the testing photodiode 8, a method for manufacturing the semiconductor laser device will be explained with reference to Figures 5A to 5D.

Referring to Figure 5A, by carrying out a series of treatments on the major surface of the wafer semiconductor substrate 1 to form a photodiode, the APC photodiode 5 and the testing photodiode 8 are formed on respective semiconductor laser device-forming regions 13, 13, ... Thereafter, the solder layers 2 for connecting the semiconductor laser chips 3 to the substrate 1 are deposited on the respective semiconductor laser device-forming regions 13, 13, ... by vaporization or selective etching. Figure 5A illustrates the state of the semiconductor laser device after the APC photodiodes 5, the testing photodiodes 8, and the solder layers 2 have been formed thereon.

Then, referring to Figure 5B, regions 14 to be scribed to partition the respective semiconductor laser device-forming regions 13,13, ... are etched to a proper depth to form grooves 15. By this etching, the inclined faces 12f and 12r are formed on the upper portions of respective front and rear end faces of the semiconductor substrates 1. When the inclined faces 12f and 12r are formed on the upper portions of both front and rear end faces of a semiconductor substrate 1 by this etching, it is possible to avoid interference that may be caused by re-reflection of the returned laser beam. Also, this etching makes the light-receiving faces of the respective photodiode elements 9a, 9b and 9c clean, whereby the light-receiving efficiency thereof is increased and inspection can be carries out accurately. These points will be described in more detail below.

When such etching is not carried out, both the front and rear end faces of the semiconductor laser device may become perpendicular to the surface of the semiconductor substrate 1 by the scribing. In such a case, when this semiconductor laser device is applied to, for example, an optical head of an optical reproducing apparatus which carried out three-beam type tracking of the laser beams emitted from the semiconductor laser chip 3 onto the optical recording medium (not shown) such as a laser disc, the lower laser beam reflected on the optical recording medium and returned to the front end face of the semiconductor substrate 1 is reflected on that front end face as it is and then returned to the original light path, since the face of the optical recording medium has a direction, or plane, the same as that of the front end face of the semiconductor substrate 1. There is then a risk that interference, which will disturb the accurate detection of the tracking error signal, will occur. However, since the upper portions of the end face of the semiconductor substrate 1, which become the sub-mount portion of the semiconductor laser device, are formed within the inclined faces 12f and 12r by the etching treatment, the lower beam, which is returned to the front end face of the semiconductor substrate 1, is reflected in a different direction to the returning direction, so that no improper influence will be exerted upon the tracking operation. Accordingly, it is possible to carry out satisfactory tracking servo control.

Also, when the etching is not carried out, the rear end portions of the respective photodiode elements 9a, 9b and 9c of the testing photodiode 8 formed on the rear end portions of the respective semiconductor device-forming regions 13, 13, ... of the semiconductor substrate 1 become coarse surfaces by the scribing, the light-receiving efficiency thereof is lowered. However, the rear end portions where the junctions of the respective photodiode elements 9a, 9b and 9c are exposed can be formed as smooth surfaces, and hence the light-receiving efficiency thereof can be improved, whereby accurate inspection or testing can be carried out.

Figure 5B illustrates the state after the etching treatment has been finished.

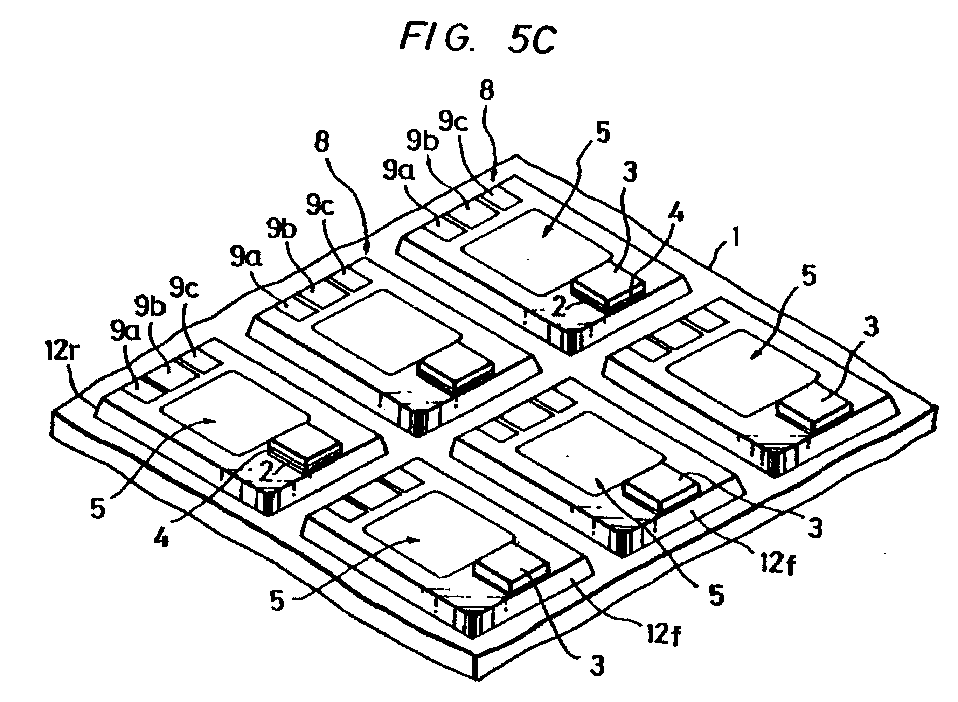

Subsequently, referring to Figure 5C, the semiconductor laser chips 3, 3, ... are positioned on the solder layers 2 of the respective semiconductor laser device-forming regions 13, 13, ... In this state, the semiconductor substrate wafer is passed through, for example a heating furnace (at a temperature of about 250° C) thereby to carry out the chip bonding of the respective semiconductor laser chips 3, 3, ... to the front regions of the respective semiconductor laser device-forming regions 13, 13, ... through the solder layers 2. Figure 5C illustrates the state after the semiconductor laser chips 3 have been bonded.

After only the chip bonding of the semiconductor laser chips 3, 3, ... has been carried out, whether the laser emission output exists or not is tested; whether the level or intensity of the laser emission output reaches the prescribed reference value or not is tested; and whether the far field pattern is symmetrical or not is tested. These tests will be described in more detail below.

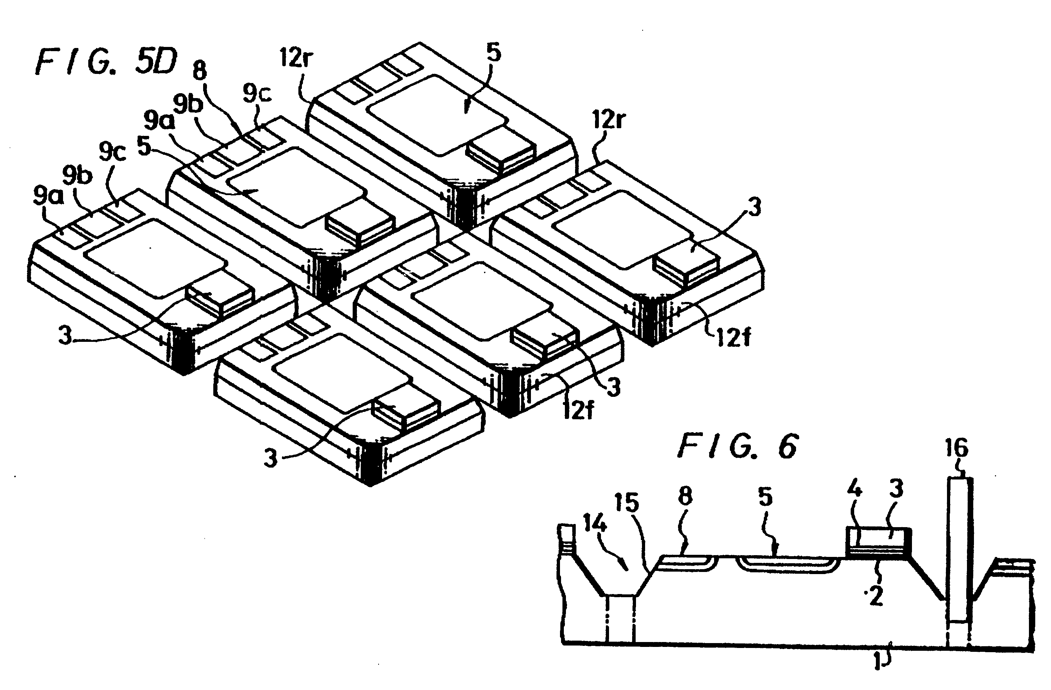

Thereafter, as Figure 5D shows, the regions 14 are cut through by sawing, thereby to complete the pelletizing. In this case, the width of the saw and the cutting position are determined so that the inclined faces 12f and 12r are not damaged by the cutting saw. Figure 5D shows the state after pelletizing.

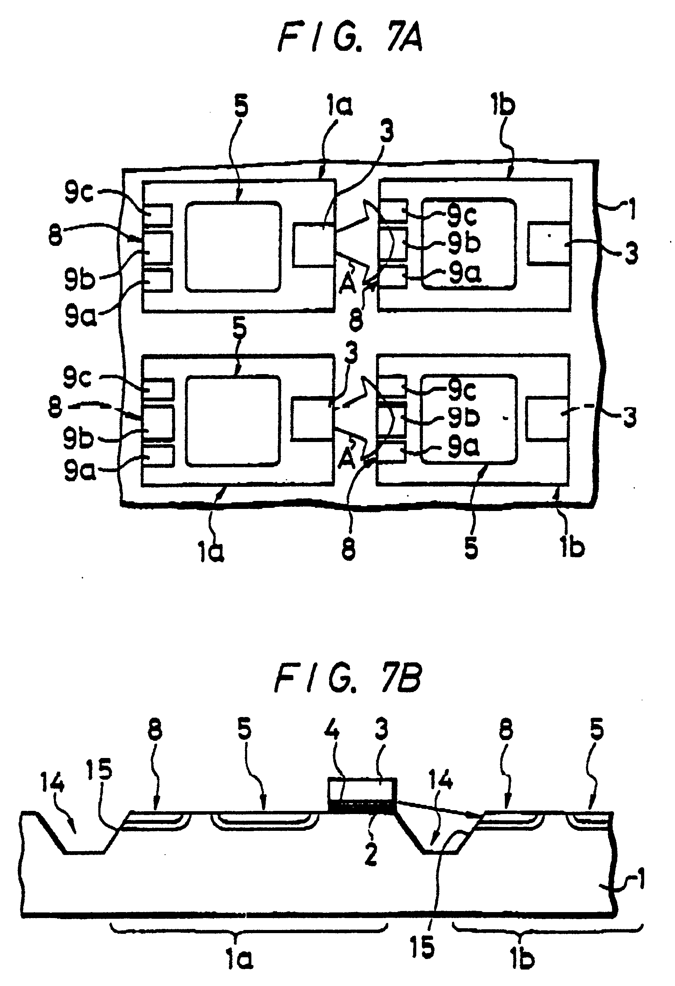

Figure 6 is a cross-sectional view showing the manner in which the region 14 is cut by a saw 16 for pelletizing. Next, with reference to Figures 7A and 7B, an explanation will be given regarding the testing method that is carried out for the laser emission output and the symmetry of the far field pattern before the pelletizing is carried out but after the chip bonding of the above mentioned semiconductor laser chips 3 has been completed.

Testing of the laser emission output and the far field pattern uses a probe. That is, with respect to one semiconductor laser device 1a, the laser emission output A from its semiconductor laser chip 3 is received by the testing photodiode 8 of another semiconductor laser device 1b adjacent to the laser device 1a at the front side thereof. More specifically, the central photodiode 9b of the laser device 1b is used to detect the laser emission output of the laser device 1a, and the ratio of the light detected by the central photodiode 9b to that of the photodiodes 9a and 9c provided at both sides of the photodiode 9b is calculated, whereby the symmetry or the far field pattern is tested.

Thus, since the testing photodiode is formed on a major surface of the semiconductor substrate at its region opposite to the bonding side of the semiconductor laser chip, in the stage before pelletizing, the testing of the laser emission output of the semiconductor laser chip in one semiconductor laser device can be carried out by using the testing photodiode of a second semiconductor laser device adjacent to the front side of the first device.

## Claims

1. A method of manufacturing and testing semiconductor laser devices comprising the steps of:
   forming an array of photodetectors (5) in one major surface of a semiconductor substrate (1), wherein each first photodetector (5) is formed in a semiconductor laser device-forming region (13);
   mounting a semiconductor laser chip (3) on the surface of each of said laser device-forming regions (13) and adjacent to said first photodetector (5);
   forming a second photodetector (8) in the surface of each of said laser device-forming regions (13) and adjacent to said first photodetector (5) and on the side therecf opposite to said laser chip (3); and
   using said second photodetector (8) to test the laser emission characteristic of a laser chip (3) on an adjacent semiconductor laser device-forming region (13) during the manufacture of the laser devices prior to pelletizing the semiconductor substrate (1).

2. A method according to claim 1 wherein said second photodetector (8) is used to test a far field pattern of laser emission of said laser chip (3) on said adjacent semiconductor laser device-forming region (13).

3. A method according to claim 2 wherein said second photodetector (8) has a radiation-sensitive region on the end face (12r) of each individual semiconductor laser device-forming region (13).

4. A method according to claim 3 wherein said second photodetector (8) comprises a plurality of photodetector elements (9a, 9b, 9c) positioned along said end face (12r).

5. A method according to any one of the preceding claims wherein said first photodetector (5) is formed as an automatic power control photodiode for said laser chip (3).

6. A semiconductor wafer comprising:
   a semiconductor substrate (1) with an array of semiconductor laser device-forming regions (13) separated by grooves (15) formed on one major surface of said semiconductor substrate (1);
   a respective first photodetector (5) formed in the surface of each said device-forming region (13);
   a respective laser chip (3) mounted on the surface of each said device-forming region (13) and adjacent to the respective said first photodetector (5); and
   a respective second photodetector (8) formed in the surface of each said device-forming region (13) and adjacent to the respective said first photodetector (5) and on the side thereof opposite to the respective said laser chip (3);
   each said second photodetector (8) being positioned to test a laser emission characteristic of a said laser chip (3) on an adjacent said device-forming region (13).

7. A wafer according to claim 6 wherein each said second photodetector (8) has a radiation-sensitive region on the end face (12r) of the respective device-forming region (13) facing said adjacent device-forming region (13).

8. A wafer according to claim 7 wherein each said second photodetector (8) comprises a plurality of photodetector elements (9a, 9b, 9c) positioned along the respective end face.

## Revendications

1. Procédé de fabrication et d'essai de dispositifs lasers à semi-conducteur, comprenant les étapes suivantes :
   la formation d'une matrice de premiers photodétecteurs (5) dans une grande face d'un substrat semi-conducteur (1), chaque premier photodétecteur (5) étant formé dans une région (13) destinée à former un dispositif laser à semi-conducteur,
   le montage d'une pastille laser à semi-conducteur (3) sur la surface de chaque région (13) destinée à former un dispositif laser et à proximité du premier photodétecteur (5),
   la formation d'un second photodétecteur (8) dans la surface de chaque région (13) destinée à former un dispositif laser et près du premier photodétecteur (5), du côté opposé à la pastille laser (3), et
   l'utilisation du second photodétecteur (8) pour la vérification de la caractéristique d'émission laser de la pastille laser (3) d'une région adjacente (13) de formation d'un dispositif laser à semi-conducteur pendant la fabrication des dispositifs lasers et avant la découpe du substrat semi-conducteur (1) sous forme de puces.

2. Procédé selon la revendication 1, dans lequel le second photodétecteur (8) est utilisé pour la vérification du diagramme en champ lointain de l'émission laser de la pastille laser (3) sur la région adjacente (13) destinée à former un dispositif laser à semi-conducteur.

3. Procédé selon la revendication 2, dans lequel le second photodétecteur (8) a une région sensible au rayonnement à la face d'extrémité (12r) de chaque région individuelle (13) destinée à former un dispositif laser à semiconducteur.

4. Procédé selon la revendication 3, dans lequel le second photodétecteur (8) comprend plusieurs éléments photodétecteurs (9a, 9b, 9c) placés le long de ladite face d'extrémité (12r).

5. Procédé selon l'une quelconque des revendications précédentes, dans lequel le premier photodétecteur (5) est réalisé sous forme d'une photodiode à réglage automatique de puissance destinée à la pastille laser (3).

6. Tranche semi-conductrice comprenant :
un substrat semi-conducteur (1) ayant une matrice de régions (13) destinée à former des dispositifs lasers à semi-conducteur, séparées par des gorges (15) formées dans une grande face du substrat semi-conducteur (1),
un premier photodétecteur respectif (5) formé à la surface de chacune des régions (13) destinées à former un dispositif,
une pastille laser respective (3) montée à la surface de chacune des régions (13) destinées à former un dispositif et près du premier photodétecteur respectif (5), et
un second photodétecteur respectif (8) formé à la surface de chaque région (13) destinée à former un dispositif et près du premier photodétecteur respectif (5) et du côté opposé à celui de la pastille laser respective (3),
chaque second photodétecteur (8) étant disposé afin qu'il vérifie la caractéristique d'émission laser d'une pastille laser (3) placée sur une région adjacente (13) destinée à former un dispositif.

7. Tranche selon la revendication 6, dans laquelle chaque second photodétecteur (8) a une région sensible au rayonnement sur la face d'extrémité (12r) de la région respective (13) destinée à former un dispositif, tournée vers la région adjacente (13) destinée à former un dispositif.

8. Tranche selon la revendication 7, dans laquelle chaque second photodétecteur (8) comporte plusieurs éléments photodétecteurs (9a, 9b, 9c) placés le long de la face respective d'extrémité.

**Patentansprüche**

1. Verfahren zum Herstellen und Testen von Halbleiter-Laservorrichtungen mit folgenden Verfahrensschritten:
Ausbilden eines Arrays von ersten Photodetektoren (5) in einer Hauptfläche eines Halbleitersubstrats (1), wobei jeder dieser ersten Photodetektoren (5) in einem für die Ausbildung einer Halbleiter-Laservorrichtung vorgesehenen Bereich (13) ausgebildet wird,
Montieren jeweils eines Halbleiter-Laserchips (3) auf der Fläche jedes der zur Ausbildung einer Halbleiter-Laservorrichtung vorgesehenen Bereiche (13) in der Nähe des ersten Photodetektors (5),
Ausbilden eines zweiten Photodetektors (8) auf der Fläche jedes der zur Ausbildung einer Halbleiter-Laservorrichtung vorgesehenen Bereiche in der Nähe des ersten Photodetektors (5) auf der dem Laserchip (3) entgegengesetzten Seite des ersten Photodetektors (5) und
Verwenden des zweiten Photodetektors (8) zum Testen der Laseremissionscharakteristik des Laserchips (3), der sich auf einem benachbarten Bereich (13) zur Ausbildung einer Halbleiter-Laservorrichtung befindet, während der Herstellung der Laservorrichtungen und vor dem Zerteilen des Halbleitersubstrats.

2. Verfahren nach Anspruch 1, bei dem der zweite Photodetektor (8) zum Testen eines Fernfeldmusters der Emission des Laserchips (3) auf dem benachbarten Bereich (13) zur Ausbildung der Halbleiter-Laservorrichtung verwendet wird.

3. Verfahren nach Anspruch 2, bei dem der zweite Photodetektor (8) einen strahlungsempfindlichen Bereich auf einer Stirnfläche (12r) jedes individuellen Bereichs zur Ausbildung einer Halbleiter-Laservorrichtung aufweist.

4. Verfahren nach Anspruch 3, bei dem der zweite Photodetektor (89 mehrere Photodetektorelemente (9a, 9b, 9c) umfaßt, die entlang der genannten Stirnfläche (12r) angeordnet sind.

5. Verfahren nach einem der vorhergehenden Ansprüche, bei dem der erste Photodetektor (5) als Photodiode zur automatischen Leistungsregelung des Laserchips (3) ausgebildet ist.

6. Halbleiterwafer mit

einem Halbleitersubstrat (1) mit einem Array von Bereichen (13) zur Ausbildung von Halbleiter-Laservorrichtungen, die durch auf einer Hauptfläche des des Halbleitersubstrats (1) ausgebildete Nuten (15) voneinander getrennt sind,

jeweils einem ersten Photodetektor (5) in der Fläche jedes der zur Ausbildung jeweils einer Halbleiter-Laservorrichtung vorgesehenen Bereiche (13),

jeweils einem Laserchip (3), der auf der Fläche jedes der zur Ausbildung einer Halbleiter-Laservorrichtung vorgesehenen Bereiche (13) und in der Nähe des ersten Photodetektors (5) montiert ist, und

jeweils einem zweiten Photodetektor (8) in der Fläche jedes der zur Ausbildung einer Halbleiter-Laservorrichtung vorgesehenen Bereiche (13), der in der Nähe des zugehörigen ersten Photodetektors (5) auf der dem zugehörigen Laserchip (3) entgegengesetzten Seite ausgebildet ist,

wobei jeder der zweiten Photodetektoren (8) so positioniert ist, daß er die Laseremissionscharakteristik eines Laserchips (3) testet, der sich auf einem benachbarten Bereich (13) zur Ausbildung einer Halbleiter-Laservorrichtung befindet.

7. Wafer nach Anspruch 6, bei dem jeder der zweiten Photodetektoren (8) einen strahlungsempfindlichen Bereich besitzt, der sich auf einer Stirnfläche (12r) des betreffenden Bereichs zur Ausbildung einer Halbleiter-Laservorrichtung befindet.

8. Wafer nach Anspruch 7, bei dem der zweite Photodetektor (89) mehrere Photodetektorelemente (9a, 9b, 9c) umfaßt, die entlang der genannten Stirnfläche (12r) angeordnet sind.

FIG. 1

FIG. 2A

FIG. 2B

FIG. 2C

# FIG. 2D

# FIG. 2E

# FIG. 3

# FIG. 4

EP 0 196 200 B1

# FIG. 5B

FIG. 5C

EP 0 196 200 B1

FIG. 5D

FIG. 6

EP 0 196 200 B1

# FIG. 7A

# FIG. 7B